(19) Europäisches Patentamt / European Patent Office / Office européen des brevets

(11) **EP 4 675 274 A1**

(12) **DEMANDE DE BREVET EUROPEEN**

(43) Date de publication:
**07.01.2026 Bulletin 2026/02**

(21) Numéro de dépôt: **25186748.7**

(22) Date de dépôt: **01.07.2025**

(51) Classification Internationale des Brevets (IPC):
*G01N 31/00* [(2006.01)]   *H01L 21/02* [(2006.01)]

(52) Classification Coopérative des Brevets (CPC):
**G01N 31/005; H01L 21/02052**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **02.07.2024 FR 2407214**

(71) Demandeur: **Commissariat à l'Energie Atomique et aux Energies Alternatives
75015 Paris (FR)**

(72) Inventeurs:
- **BOUTRY, Delphine**
  **38054 Grenoble cedex 09 (FR)**
- **LARDIN, Thierry**
  **38054 Grenoble cedex 09 (FR)**
- **GABETTE, Laurence**
  **38054 Grenoble cedex 09 (FR)**
- **LOUP, Virginie**
  **38054 Grenoble cedex 09 (FR)**

(74) Mandataire: **Ipsilon
12 Avenue d'Italie
75013 Paris (FR)**

(54) **PROCÉDÉ UTILE POUR DÉTECTER ET/OU DOSER TOUT MÉTAL NOBLE EN SURFACE D'UN SUBSTRAT DE PHOSPHURE D'INDIUM (INP)**

(57) L'invention a pour objet un procédé utile pour détecter et/ou doser tout métal noble en surface d'un substrat de phosphure d'indium (InP), comprenant au moins les étapes suivantes : a) la mise en contact de l'InP dudit substrat, avec une solution iodée comprenant en outre au moins un agent oxydant non iodé et différent de l'eau oxygénée pour dissoudre ledit métal noble, si présent, dans ladite solution ; b) la récupération de ladite solution ayant été mise en œuvre en a) ; c) le cas échéant, la répétition de a) et b) avec une solution iodée exempte de métal noble ; et d) l'analyse par spectrométrie de masse à plasma à couplage inductif de la solution récupérée en b), et le cas échéant en c).

EP 4 675 274 A1

**Description**

**Domaine technique**

La présente invention se rapporte à la caractérisation de métaux nobles, contaminants susceptibles d'être présents en surface de substrats formés d'un matériau de type phosphure d'indium.

**Technique antérieure**

La production d'un dispositif micro-électronique entraîne la mise en place d'une séquence de nombreuses étapes et est sujette à l'apparition de défauts ou imperfections. Ces défauts incluent notamment la présence non contrôlée et non désirée de contaminants, notamment métalliques. Ces contaminants sont en particulier des métaux nobles tels que l'or Au, l'argent Ag, le ruthénium Ru, le rhodium Rh, le palladium Pd, l'osmium Os, l'iridium Ir et le platine Pt.

Pour des raisons évidentes, il importe de pouvoir minimiser significativement ce type de contamination dans les dispositifs micro-électroniques et donc de disposer d'outils de contrôle efficaces à cet égard.

Généralement, la caractérisation d'une telle contamination métallique s'effectue sur des surfaces de substrats silicium par spectrométrie de fluorescence des rayons X en réflexion totale ou TXRF (de l'anglais, *Total X-Ray Reflection Fluorescence*), et par décomposition en phase vapeur couplée avec ICP-MS ou VPD-ICP-MS (de l'anglais *Vapor phase Decomposition-Inductively coupled Plasma Mass Spectroscopy*). Ces techniques apportent de très bonnes limites de détection (LLD) allant de $10^8$ à $10^{11}$ atomes par centimètres carrés pour la plupart des contaminants métalliques, standards et nobles.

La technologie TXRF permet également de détecter et/ou doser la plupart des contaminants métalliques sur des surfaces de substrats de phosphure d'indium. Toutefois, les LLD demeurent moins performantes que celles obtenues sur des substrats silicium. Ceci est dû à l'interférence de nombreuses raies d'indium provenant du substrat InP avec des raies de contaminants métalliques, entre 2 et 5 keV, et une augmentation du bruit de fond des spectres. Une interférence est notamment présente lors de la caractérisation du métal argent dont les raies analysées se trouvent aux alentours de 3 keV, cet élément n'étant pas quantifiable en dessous de $10^{14}$ at/cm$^2$.

Par ailleurs, l'analyse par VPD-ICP-MS n'est pas possible sur des surfaces de substrats de phosphure d'indium puisque l'InP est hydrophile : la collecte des contaminants par une goutte d'acide n'est pas possible, et de plus, l'équipement VPD serait contaminé en indium. Une alternative à l'analyse par VPD-ICP-MS est la collecte par décomposition en phase liquide couplée avec un ICP-MS, soit LPD-ICPMS (de l'anglais *Liquid Phase Decomposition-Inductively coupled Plasma Mass Spectroscopy*), dont l'efficacité a seulement été validée pour collecter les éléments standards et donc différents d'un métal noble, d'une surface de substrat InP. Une solution de HNO$_3$ à 1 % molaire a notamment permis d'atteindre un taux de collecte de tels éléments standards supérieur à 90 %. Cette même solution a été testée pour analyser les éléments nobles mais dans ce cas-ci, le taux de collecte était proche de 0 %.

En conséquence, à la connaissance des inventeurs, il n'existe pas ce jour de méthode efficace et sécurisée pour contrôler la présence éventuelle de métaux nobles à l'image notamment de l'argent Ag, voire les doser, sur des substrats de phosphure d'indium InP.

La présente invention a précisément pour objectif de répondre à cette attente.

**Exposé de l'invention**

L'invention a ainsi pour objet un procédé utile pour détecter et/ou doser tout métal noble en surface d'un substrat de phosphure d'indium (InP), comprenant au moins les étapes suivantes :

a) la mise en contact du phosphure d'indium InP dudit substrat, avec une solution iodée comprenant en outre au moins un agent oxydant non iodé et différent de l'eau oxygénée pour dissoudre ledit métal noble, si présent, dans ladite solution ;
b) la récupération de ladite solution ayant été mise en œuvre à l'étape a) ;
c) le cas échéant, la répétition des étapes a) et b) avec une solution iodée exempte de métal noble et comprenant en outre au moins un agent oxydant non iodé et différent de l'eau oxygénée ; et
d) l'analyse par spectrométrie de masse à plasma à couplage inductif (ICPMS) de la solution récupérée en b), et le cas échéant en c).

**Résumé de l'invention**

Ainsi, les inventeurs ont constaté qu'il est possible de collecter efficacement des métaux nobles en surface d'un matériau de type phosphure d'indium (InP) par voie chimique, et plus particulièrement à l'aide d'une solution iodée conforme à l'invention.

Certes, il est déjà connu de traiter des surfaces d'InP avec des solutions oxydantes, mais pour l'essentiel à des fins de gravure chimique de l'InP et donc pour un objectif bien différent de celui considéré selon l'invention. En outre, les solutions oxydantes retenues à cette fin sont différentes de celles de l'invention. Ainsi, la publication [1] décrit la gravure chimique notamment d'InP à l'aide de solutions de $HCl:CH_3COOH:H_2O_2$. Un dégagement indésirable et dangereux de phosphine est d'ailleurs constaté dans les conditions préconisées (Notten P.H.L. 1984. This Journal, 131, 2641). Pour sa part, la publication [2] décrit la gravure chimique d'InP avec des solutions d'acide iodique ($HIO_3$) de teneurs variées.

Comme il ressort des exemples ci-après, le procédé selon l'invention permet avantageusement l'obtention d'un taux de collecte supérieur à 93 % pour un temps de collecte court, et ceci sans dégagement de phosphine. Le procédé selon l'invention autorise donc une qualification voire une quantification, fiable et sans risque, de tels contaminants. Selon un autre de ses aspects, la présente invention vise un procédé de nettoyage d'un substrat de phosphure d'indium contaminé par au moins un métal noble, comprenant la mise en contact répétée ou non, du phosphure d'indium InP dudit substrat, avec une solution iodée exempte de métal noble et comprenant en outre au moins un agent oxydant non iodé et différent de l'eau oxygénée dans des conditions propices à une dissolution dudit métal noble, si présent, dans ladite solution.

**Description détaillée**

Comme il ressort de ce qui précède, le procédé selon l'invention comprend au moins une étape de collecte et, consécutivement, une étape d'analyse.

En particulier, cette première étape est une étape de collecte par voie chimique liquide, dite encore LPD.

Plus précisément, elle repose sur la mise en contact du phosphure d'indium du substrat à caractériser avec une solution iodée spécifique.

Les inventeurs ont en effet découvert qu'une solution iodée complémentée avec un agent oxydant non iodé et différent de l'eau oxygénée s'avère tout particulièrement efficace pour garantir la collecte de quasi l'intégralité des métaux nobles présents en surface d'un tel matériau, et ceci en un temps réduit.

Solution iodée

Au sens de l'invention, une solution iodée est une solution comprenant au moins du diiode et/ou au moins un iodure de métal alcalin.

Avantageusement, l'iodure de métal alcalin est au moins l'iodure de potassium.

En particulier, la solution iodée comprend une teneur en diiode allant de 0,001 % à 15 % en poids, de préférence de 0,01 % à 10 % en poids, plus préférentiellement de 0,05 % à 5 % en poids, par rapport au poids total de la solution iodée.

En particulier, la solution iodée comprend une teneur en iodure de métal alcalin allant de 0,001 % à 15 % en poidss, de préférence de 0,01 % à 12 % en poids, plus préférentiellement de 0,05 % à 10 % en poids, par rapport au poids total de la solution iodée.

À titre illustratif et non limitatif d'une telle solution iodée, peut notamment être citée celle contenant de 0,001 % à 15 % en poids en diiode et de 0,001 % à 15 % en poids en iodure de potassium, par rapport au poids total de la solution iodée.

Dans le cadre de la présente invention, cette solution iodée comprend en outre au moins un agent oxydant non iodé et différent de l'eau oxygénée.

Avantageusement, cet agent oxydant non iodé selon l'invention est choisi parmi l'acide nitrique $HNO_3$.

Selon un mode de réalisation préféré, cette solution iodée contient au moins de l'acide nitrique.

Comme il ressort des exemples ci-après, la présence de ce dernier, qui est seul inefficace pour dissoudre des métaux nobles, s'avère capable de stimuler significativement l'efficacité d'une solution iodée.

De préférence, la solution iodée comprend une teneur en agent oxydant non iodé et différent de l'eau oxygénée, de préférence en acide nitrique $HNO_3$, allant de 0,001 % à 10 % en poids, de préférence de 0,01 % à 5 % en poids, plus préférentiellement de 0,05 % à 2,5 % en poids, par rapport au poids total de la solution iodée.

À titre illustratif et non limitatif d'une solution iodée conforme à l'invention peut notamment être cité celle contenant de 0,001 à 15 % en poids en diiode, de 0,001 % à 15 % en poids en iodure de potassium et de 0,001 % à 10 % en poids en acide nitrique, par rapport au poids total de la solution iodée.

Comme il ressort des exemples ci-après, une telle solution s'avère particulièrement optimale pour assurer un taux de collecte efficace des métaux nobles, si présents, et donc pour garantir une bonne fiabilité de la méthode de caractérisation revendiquée.

La durée de mise en contact de la surface du substrat avec la solution iodée est généralement inférieure ou égale à 15 minutes, de préférence varie de 30 secondes à 10 minutes, plus préférentiellement de 1 à 5 minutes, mieux elle est de 5 minutes.

Selon une variante, l'étape de mise en contact est répétée une ou plusieurs fois avec une solution iodée exempte de métal noble. En d'autres termes, une solution iodée conforme à la présente invention ayant déjà été mise en œuvre en étape a) n'est pas retenue pour une seconde utilisation de collecte. Une étape de rinçage et/ou de séchage peut éventuellement être mise en œuvre entre les étapes de mise en contact.

Selon un mode de réalisation, le rinçage s'effectue avec de l'eau déionisée.

La deuxième étape du procédé de l'invention repose pour sa part sur la mise en œuvre d'une analyse par spectrométrie de masse à plasma à couplage inductif (ICP-MS) de la ou les solutions récupérées à l'issue d'au moins une mise en contact avec la surface à caractériser en métaux nobles contaminants.

L'invention va maintenant être décrite au moyen des exemples suivants, donnés bien entendu à titre illustratif et non limitatif de l'invention.

## Matériels et méthodes

Des plaquettes neuves de phosphure d'indium de diamètre 100 mm sont contaminées volontairement par tournette (en anglais *spin-drying*) afin de simuler une contamination de surface des métaux Ag, Au et Pt.

Les concentrations de contamination volontaire se situent entre $10^{12}$ et $10^{13}$ at/cm$^2$ et sont calculées grâce à des abaques de contamination. Ces concentrations déposées en Au et Pt sont contrôlées par TXRF, ce qui est possible car il n'y a pas d'interférences des raies de ces métaux avec les raies d'In. Enfin, les plaquettes sont laissées à sécher pendant 24 h.

Un détecteur de phosphine $PH_3$ portatif de type DRAEGER X-AM5 100 ou DRAEGER 7000 a été utilisé afin de détecter et/ou contrôler les dégagements de phosphine lors de l'étape de collecte.

## Exemple

## Exemple 1

## Traitement d'un substrat InP selon l'invention et hors invention

Les teneurs sont exprimées en pourcentage pondéral.

Deux solutions iodées sont préparées à partir de diiode et d'iodure de potassium :

- solution iodée 1 : teneur en $I_2$ de 2,6 % et teneur en KI inférieure à 10 % ;
- solution iodée 2 : teneur en $I_2$ de 0,26 % et teneur en KI inférieure à 1 %.

Dans la solution iodée 1 est ajouté de l'acide nitrique $HNO_3$ à une concentration de 2 %, dans la solution iodée 2 est ajouté de l'acide nitrique $HNO_3$ à une concentration de 0,1 %.

Une troisième solution iodée, comparative, est préparée à partir de diiode (teneur de 2,6 %) et d'iodure de potassium (teneur inférieure à 10 %).

Ces trois solutions sont testées sur une plaquette neuve de phosphure d'indium contaminée en Ag, Au et Pt telle que détaillée ci-dessus.

Chaque solution est mise en contact avec une plaquette neuve de phosphure d'indium durant 5 minutes, puis une fraction de cette solution est prélevée. La plaquette de phosphure d'indium est rincée à l'eau déionisée, puis séchée. Cette procédure est ensuite répétée deux fois, à chaque fois avec un nouveau lot de la solution iodée initialement considérée.

Trois LPD successives sont donc réalisées sur chaque plaquette d'InP afin de calculer le taux de collecte, défini selon l'équation suivante :

$$C1/(C1+C2+C3) \times 100$$

avec C1 la concentration mesurée via ICP-MS pour la collecte par LPD numéro 1, C2 la concentration mesurée via ICP-MS pour la collecte par LPD numéro 2, C3 la concentration mesurée via ICP-MS pour la collecte par LPD numéro 3.

Les solutions obtenues à la collecte sont analysées par ICP-MS (ICPMS 7900 Agilent).

Le tableau 1 ci-après rend compte des taux de collecte obtenus. Il précise également des résultats obtenus avec une solution comparative de collecte car ne comprenant que de l'acide nitrique.

[Tableau 1]

| Solutions | Taux de collecte (%) | | |
|---|---|---|---|
| | Ag | Au | Pt |
| Solution $I_2$ à 2,6% + KI [<10%] + $HNO_3$ 2% (invention) | 99 | 99 | 99 |
| Solution $I_2$ à 0,26% + KI [<1%] + $HNO_3$ 0,1% (invention) | 98 | 97 | 94 |
| Solution I2 à 2,6% + KI [<10%] (comparatif) | 77 | 55 | 68 |
| Solution $HNO_3$ à 5% (comparatif) | <10 | <10 | <10 |

De ces données, il ressort que seules les solutions de collecte conformes à l'invention s'avèrent efficaces, d'une part, pour l'ensemble des métaux nobles présents sur la surface traitée, et d'autre part, en termes de taux de collecte puisque ceux-ci sont supérieurs à 94 % pour chacun des métaux nobles.

Il est également constaté que l'acide nitrique seul est inefficace, et ceci même à une concentration plus élevée que la concentration d'acide nitrique dans chacune des solutions selon l'invention.

Quant à la solution iodée non complémentée en acide nitrique, elle ne s'avère pas d'efficacité égale à l'égard des 3 métaux nobles, et les taux de collectes obtenus sont bien inférieurs à ceux obtenus avec les solutions de collecte conformes à l'invention.

Il apparaît que la présence d'acide nitrique, très peu efficace seul, stimule significativement l'activité de la solution iodée.

## Liste des documents cités

[1] Flemish J. R., Jones K. A. 1993. Selective Wet Etching of GaInP, GaAs and InP in Solutions of HCl, CH3COOH, and H2O2, J. Electrochem. Soc., 140, 844.

[2] Sundararaman C.S., Mouton A., Currie J.F. 1990. Chemical Etching of InP. International Conference on Indium Phosphide and Related Materials, Denver, CO, USA, 224-227.

[3] Hiromu Ishii, Shouji Yagi, Tadashi Minotani, Yakov Royter, Kazuhisa Kudou, Masaki Yano, Tadao Nagatsuma, Katsuyuki Machida, and Hakaru Kyuragi. 2001. Gold damascene interconnect technology for millimeter-wave photonics on silicon, Micromachining and Microfabrication Process Technology VII, Proc. SPIE, Vol. 4557, 210-219.

## Revendications

1.   Procédé utile pour détecter et/ou doser tout métal noble en surface d'un substrat de phosphure d'indium (InP), comprenant au moins les étapes suivantes :

   a) la mise en contact du phosphure d'indium InP dudit substrat, avec une solution iodée comprenant en outre au moins un agent oxydant non iodé et différent de l'eau oxygénée pour dissoudre ledit métal noble, si présent, dans ladite solution ;
   b) la récupération de ladite solution ayant été mise en œuvre à l'étape a) ;
   c) le cas échéant, la répétition des étapes a) et b) avec une solution iodée exempte de métal noble et comprenant en outre au moins un agent oxydant non iodé et différent de l'eau oxygénée ; et
   d) l'analyse par spectrométrie de masse à plasma à couplage inductif (ICPMS) de la solution récupérée en b), et le cas échéant en c).

2.   Procédé selon la revendication précédente, dans lequel la solution iodée est une solution comprenant au moins du diiode et/ou au moins un iodure de métal alcalin.

3.   Procédé selon la revendication précédente, dans lequel l'iodure de métal alcalin est au moins l'iodure de potassium.

4.   Procédé selon l'une quelconque des revendications précédentes, dans lequel la solution iodée comprend une teneur en diiode allant de 0,001 % à 15 % en poids, de préférence de 0,01 % à 10 % en poids, plus préférentiellement de 0,05 % à 5 % en poids, par rapport au poids total de la solution iodée.

**5.** Procédé selon l'une quelconque des revendications précédentes, dans lequel la solution iodée comprend une teneur en iodure de métal alcalin allant de 0,001 % à 15 % en poids, de préférence de 0,01 % à 12 % en poids, plus préférentiellement de 0,05 % à 10 % en poids, par rapport au poids total de la solution iodée.

**6.** Procédé selon l'une quelconque des revendications précédentes, dans lequel l'agent oxydant non iodé et différent de l'eau oxygénée est l'acide nitrique $HNO_3$.

**7.** Procédé selon l'une quelconque des revendications précédentes, dans lequel la solution iodée comprend une teneur en diiode allant de 0,001 à 15 % en poids, de préférence de 0,01 % à 10 % en poids, plus préférentiellement de 0,05 % à 5 % en poids; une teneur en iodure de potassium allant de 0,001 % à 15 % en poids, de préférence de 0,01 % à 12 % en poids, plus préférentiellement de 0,05 % à 10 % en poids; une teneur en acide nitrique $HNO_3$ allant de 0,001 % à 10 % en poids, de préférence de 0,01 % à 5 % en poids, plus préférentiellement de 0,05 % à 2,5 % en poids, par rapport au poids total de la solution iodée.

**8.** Procédé de nettoyage d'un substrat de phosphure d'indium contaminé par au moins un métal noble, comprenant la mise en contact, répétée ou non, du phosphure d'indium InP dudit substrat, avec une solution iodée exempte de métal noble et comprenant en outre au moins un agent oxydant non iodé et différent de l'eau oxygénée pour dissoudre ledit métal noble, si présent, dans ladite solution.

Europäisches
Patentamt

European
Patent Office

Office européen
des brevets

**RAPPORT DE RECHERCHE EUROPEENNE**

Numéro de la demande

EP 25 18 6748

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | HERVÉ FONTAINE ET AL: "Quantitative Analysis of the Metallic Contamination On GaAs and InP Wafers by TXRF and ICPMS Techniques", ECS TRANSACTIONS, US, vol. 58, no. 6, 31 août 2013 (2013-08-31), pages 327-335, XP093248187, ISSN: 1938-5862, DOI: 10.1149/05806.0327ecst | 1-6 | INV. G01N31/00 H01L21/02 |
| A | * abrégé; figure 4; tableau II * <br> * page 327, alinéa Introduction * <br> * page 328, lignes 4-8 * <br> * page 329, alinéa 4 * <br> * page 332, alinéa 1-3 * <br> * page 334, alinéa Conclusion * <br> ----- | 7,8 | |
| X | CN 101 445 934 B (NANCHANG SUNRISE OPTECH CO LTD) 20 avril 2011 (2011-04-20) | 8 | |
| Y | * revendication 1; exemple 1 * | 1-6 | |
| A | * alinéas [0004], [0021] * <br> ----- | 7 | DOMAINES TECHNIQUES RECHERCHES (IPC) |
| A | HERVÉ FONTAINE ET AL: "Analysis of the Noble Metals on Silicon Wafers by Chemical Collection and ICPMS", FRONTIERS OF CHARACTERIZATION AND METROLOGY FOR NANOELECTRONICS, vol. 1395, 23 mai 2011 (2011-05-23), pages 222-226, XP093248188, DOI: 10.1063/1.3657895 <br> * abrégé * <br> * page 223, alinéa Experimental * <br> ----- | 1-8 | G01N H01L |

Le présent rapport a été établi pour toutes les revendications

| Lieu de la recherche | Date d'achèvement de la recherche | Examinateur |
|---|---|---|
| Munich | 11 novembre 2025 | Hanisch, Christian |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

................................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 25 18 6748

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

11-11-2025

| Document brevet cité au rapport de recherche | Date de publication | Membre(s) de la famille de brevet(s) | Date de publication |
|---|---|---|---|
| CN 101445934 B | 20-04-2011 | AUCUN | |

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **NOTTEN P.H.L.** *This Journal*, 1984, vol. 131, 2641
- **FLEMISH J. R.** ; **JONES K. A.** ; **1993**. Selective Wet Etching of GaInP, GaAs and InP in Solutions of HCl, CH3COOH, and H2O. *J. Electrochem. Soc.*, vol. 140, 844
- **SUNDARARAMAN C.S.** ; **MOUTON A.** ; **CURRIE J.F**. Chemical Etching of InP. *International Conference on Indium Phosphide and Related Materials, Denver, CO, USA*, 1990, 224-227

- **HIROMU ISHII** ; **SHOUJI YAGI** ; **TADASHI MINOTANI** ; **YAKOV ROYTER** ; **KAZUHISA KUDOU** ; **MASAKI YANO** ; **TADAO NAGATSUMA** ; **KATSUYUKI MACHIDA** ; **HAKARU KYURAGI.** Gold damascene interconnect technology for millimeter-wave photonics on silicon, Micromachining and Microfabrication Process Technology VII. *Proc. SPIE*, 2001, vol. 4557, 210-219